(19) Europäisches Patentamt
European Patent Office
Office européen des brevets

(11) Veröffentlichungsnummer: **0 107 621**
**B1**

(12) # EUROPÄISCHE PATENTSCHRIFT

(45) Veröffentlichungstag der Patentschrift: **23.01.91**

(51) Int. Cl.$^5$: **G 03 F 7/038**

(21) Anmeldenummer: **83810478.4**

(22) Anmeldetag: **17.10.83**

(54) **Zur positiven Bilderzeugung geeignete Stoffgemische, Verfahren zur positiven Bilderzeugung und die damit erhaltenen Bilder.**

(30) Priorität: **22.10.82 GB 8230302**
**09.08.83 GB 8321379**

(43) Veröffentlichungstag der Anmeldung:
**02.05.84 Patentblatt 84/18**

(45) Bekanntmachung des Hinweises auf die Patenterteilung:
**23.01.91 Patentblatt 91/04**

(84) Benannte Vertragsstaaten:
**BE CH DE FR GB IT LI NL SE**

(56) Entgegenhaltungen:
**EP-A-0 054 151**
**GB-A-1 467 226**
**US-A-3 898 087**
**IBM TECHNICAL DISCLOSURE BULLETIN, Band 17, Nr. 6, November 1974, Seite 1577, New York, US; M.J. CANESTARO et al.: "Water developable photosensitive dielectric"**
**PATENTS ABSTRACTS OF JAPAN, Band 6, Nr. 175 (P-141)1053r, 9. September 1982; & JP-A-57 92 332 (TOYO BOSEKI K.K.) 08-06-1982**

(73) Patentinhaber: **CIBA-GEIGY AG**
**Klybeckstrasse 141**
**CH-4002 Basel (CH)**

(72) Erfinder: **Irving, Edward, Dr.**
**41, Swaffham Road**
**Burwell Cambridge CB5 0AN (GB)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 107 621 B1

## Beschreibung

Die Erfindung betrifft neue zur positiven Bilderzeugung geeignete Stoffgemische, ein Verfahren zur Bilderzeugung unter Verwendung eines positiven Photoresist sowie die damit auf einem Substrat erzeugten Bilder.

Bei der Bilderzeugung mittels positiver Photoresist werden die aktinischer Strahlung ausgesetzten Teile des Photoresist im Vergleich zu den nicht belichteten Stellen in Entwicklern löslicher gemacht, oder sie kònnen durch den Entwickler leichter entfernt werden. Die bestrahlten Stellen können daher durch den Entwickler entfernt werden, wobei die nicht bestrahlten Stellen unverändert bleiben und ein positives Bild ergeben. Solche Verfahren zur Bilderzeugung eignen sich vor allem zur Herstellung von Druckplatten und gedruckten Schaltungen. Die bei der Bilderzeugung verwendeten Entwickler enthalten im allgemeinen organische Lösungsmittel. Seit einiger Zeit ist man jedoch bestebt, von lösungsmittelhaltigen Systemen zu wässrigen Entwicklern überzugehen, um damit die mit der Verwendung von Lösungsmitteln verbundenen Risiken in Bezug auf Toxizität, Entflammbarkeit und Umweltverschmutzung zu vermeiden.

In der britischen Patentschrift 1.467.226 und der Zusatzpatentschrift 1.512.973 werden bestimmte strahlungsempfindliche, in organischen Lösungsmitteln lösliche Präpolymere beschrieben und zwar Polyadditions- oder Polykondensaitonsprodukte aus

(1) mindestens einer mehrwertigen carbocyclischen und/oder heterocyclischen Verbindung, enthaltend

(a) mindestens zwei zu Additions- oder Kondensationsreaktionen befähigten Gruppen R und

(b) mindestens eine strahlungsempfindliche Gruppe —COOR$^1$, worin die Gruppe(n) R$^1$ einen organischen Rest mit einer oder mehr Doppel- oder Dreifachbindungen, die unter Bestrahlung dimerisieren oder polymerisieren können, darstellen und die Gruppen —COOR$^1$ in ortho- oder peri-Stellung zu einer Gruppe R stehen, und

(2) mindestens einer mehrwertigen carbocyclischen und/oder heterocyclischen Verbindung mit mindestens zwei Gruppen, welche mit den Gruppe R Additions- oder Kondensationsreaktionen eingehen können.

Geeignete Kombinationen von funktionellen, zu Additions- oder Kondensationsreaktionen befähigten Gruppen sind z.B. Chloride mit Aminen oder Säuren mit Isocyanaten zur Herstellung von Polyamiden, Amine mit Isocyanaten zur Herstellung von Polyharnstoffen, sowie Phenole oder Polyole mit Isocyanaten zur Herstellung von Polyurethanen. Als Beispiele von geeigneten durch Strahlung dimeriserbaren oder polymerisierbaren Gruppen seien die Allyl-, Acryloyl- und Methacryloylgruppen genannt. Nach der Bestrahlung und Entwicklung durch Behandlung mit organischen Lösungsmittel ergeben diese Präpolymere negative Bilder.

In der deutschen Offenlegungsschrift 29 33 826 sind oligomere und/oder polymere Vorläufer zur Herstellung von Polyimiden, Polyisoindolochinazolindionen, Polyoxazindionen und Polychinazolindionen beschrieben. Diese Vorläufer sind strahlungsempfindlich und stellen Additionsprodukte olefinisch ungesättigter Monoepoxide, wie Glycidylacrylat oder -methacrylat, mit einem carbonsäuregruppenhaltigen Polyadditionsprodukt aus einem aromatischen und/oder heterocyclischen Tetracarbonsäureanhydrid und einem in ortho-Stellung gegebenenfalls eine Amidgruppe aufweisenden Diamin, oder mit einem carbonsäuregruppenhaltigen Polyadditionsprodukt aus einer aromatischen und/oder heterocyclischen Dihydroxydicarbonsäure oder der entsprechenden Diaminodicarbonsäure und Diisocyanaten dar. Geeignete Tetracarbonsäuredianhydride sind z.B. Pyromellitsäuredianhydrid und Benzophenontetracarbonsäuredianhydride. Für die Umsetzung mit den Tetracarbonsäuredianhydriden können z.B. 4,4'-Diaminodiphenyläther und 4,4'-Diaminodiphenyl-3,3'-dicarbonsäureamid verwendet werden. Beispiele geeigneter Hydroxysäuren bzw. Aminosäuren sind 4,4'-Dihydroxydiphenylmethan-3,3'-dicarbonsäure bzw. 4,4'-Diaminodiphenyl-3,3'-dicarbonsäure. Als Diisocyanat, das mit der Hydroxy- oder Aminosäure umgesetzt werden kann, sei z.B. 4,4'-Diphenylmethandiisocyanat genannt.

Nach der Photopolymerisation und dem Entwickeln mit einem Lösungsmittel kann das das negative Bild bildende verbliebene Polymer erhitzt werden, wobei die lichtvernetzbaren Gruppen eliminiert werden und unter Ringbildung "leitern-förmige" Strukturen gebildet werden. Derartige Polymere sind gegen weiteres Erhitzen äusserst beständig. Einige Einzelheiten über solche Photopolymere, deren Vernetzung, thermischen Ringschluss und deren Verwendung finden sich z.B. in Photographic Science and Engineering, *23*, 303—309 (1979) [R. Rubner et al.]. Es wurde nun gefunden, dass in wässrigem basischem Medium entwickelbare positive Photoresists dadurch erhalten werden können, dass man die in den oben erwähnten Patentschriften beschriebenen lichtempfindlichen Präpolymere mit bestimmten strahlungsempfindlichen ungesättigten Carbonsäuren zu neuen Stoffgemischen vermischt und diese bestrahlt. Ein derartiges Verhalten ist in den genannten Literaturstellen weder beschrieben noch nahegelegt. In diesen Literaturstellen wird nur die Herstellung von negativen Bildern unter Verwendung von organischen Lösungsmitteln als Entwickler beschrieben.

Dementsprechend betrifft die Erfindung ein Stoffgemisch enthaltend

(i) ein in organischen Lösungsmitteln lösliches, strahlungsempfindliches Präpolymer, das ein Polyadditions- oder Polykondensationsprodukt ist aus

(1) mindestens einer mehrwertigen carbocyclischen Verbindung und/oder heterocyclischen Verbindung mit mindestens zwei zu Additions- oder Kondensatonsreaktionen befähigten Gruppen R und

(2) mindestens einer mehrwertigen carbocyclischen Verbindung und/oder heterocyclischen Verbindung mit mindestens zwei Gruppen, die mit den Gruppen R Additions- oder Kondensationsreaktionen eingehen können, wobei das Präpolymer mindestens eine Gruppe $—COOR^1$ in ortho- oder peri-Stellung zu einer durch Umsetzung der Gruppe R gebildeten Gruppe aufweist und $R^1$ einen organischen Rest mit einer oder mehr Doppel- oder Dreifachbindungen, die unter Bestrahlung dimerisieren oder polymerisieren können, darstellt, und

(ii) 1—25 Gew.%, bevorzugt 2—10 Gew.%, bezogen auf das Gewicht des Präpolymeren (i), einer umgesättigten Mono- oder Dicarbonsäure der Formel I

$$CH_2=\underset{\displaystyle R^2}{\underset{|}{C}}-COOR^3 \qquad (I),$$

worin $R^2$ ein Wasserstoffatom oder eine Methylgruppe und $R^3$ ein Wasserstoffatom oder eine über eine Estergruppe an eine aromatische oder aliphatische Mono- oder Dicarbonsäure gebundene Alkylenkette, die eine oder zwei weitere Gruppen

$$CH_2=\underset{\displaystyle R^2}{\underset{|}{C}}—COO—$$

enthalten kann, darstellen.

Die in organischen Lösungsmitteln löslichen strahlungsempfindlichen Präpolymeren (i) können dadurch hergestellt werden, dass man

(3) mindestens eine mehrwertige carbocyclische Verbindung und/oder heterocyclische Verbindung mit mindestens zwei Gruppen R und mindestens einer Gruppe $—COOR^1$ in ortho- oder peri-Stellung zu einer Gruppe R (Gruppen R und $—COOR^1$ wie oben definiert) und

(4) mindestens eine mehrwertige carbocyclische Verbindung und/oder heterocyclische Verbindung mit mindestens zwei Gruppen, die mit den Gruppen R Additions- oder Kondensationsreaktionen eingehen können, umsetzt.

Gemäss einer typischen Ausführungsform wird ein Tetracarbonsäuredianhydrid mit einem Hydroxyalkylacrylat oder -methacrylat zu einem Diester mit zwei freien Carbonsäuregruppen umgesetzt. Die so erhaltene Verbindung, z.B. Polyamide, oder andere Säuren mit zwei oder mehr Carbonsäuregruppen und einer oder mehreren Gruppen $—COOR^1$ können in die entsprechenden Säurechloride übergeführt werden, die dann mit Verbindungen mit zwei oder mehr Aminogruppen umgesetzt werden können.

Die Säuren können auch mit Verbindungen mit zwei oder mehr Isocyanatgruppen umgesetzt werden. In beiden Fällen ist das erhaltene Präpolymer ein Plyamid mit Alkylenacrylat- oder -methacrylatgruppen bzw. anderen lichtempfindlichen Gruppen, die über eine Esterbindung an die Polyamidkette gebunden sind.

Die in organischen Lösungsmitteln löslichen strahlungsempfindlichen Präpolymeren (i) können auch dadurch hergestellt werden, dass man ein carbonsäuregruppenhaltiges Polyadditions- oder Polykondensationsprodukt aus

(5) mindestens einer mehrwertigen carbocyclischen Verbindung und/oder heterocyclischen Verbindung mit mindestens zwei Gruppen R und

(6) mindestens einer mehrwertigen carbocyclischen Verbindung und/oder heterocyclischen Verbindung mit mindestens zwei Gruppen, die mit den Gruppen R eine Additions- oder Kondensationreaktion eingehen können, mit

(7) einer Verbindung umsetzt, die mindestens eine Gruppe $—COOR^1$ und eine zur Umsetzung mit Carbonsäuregruppen geeignete Gruppe aufweist, wobei sich die Carbonsäuregruppe in dem Polyadditions- oder Polykondensationsprodukt in ortho- oder peri-Stellung zu der durch Umsetzung einer Gruppe R gebildeten Gruppe bzw. zu den durch Umsetzung von Gruppen R gebildeten Gruppen befindet.

Nach dieser Verfahrensvariante wird beispielsweise ein Tetracarbonsäuredianhydrid mit einem Diamin zu einem Polyamid mit freien Carbonsäuregruppen umgesetzt. Diese freien Carbonsäuregruppen werden mit einem Glycidylacrylat oder -methacrylat zu Polyamiden mit seitenständigen 3-Acryloyloxy- oder 3-Methacryloyloxy-2-hydroxypropyloxycarbonylgruppen umgesetzt.

Gegenstand der Erfindung ist auch ein Verfahren zur positiven Bilderzeugung, indem man

A) auf ein Substrat eine Schicht aus einem erfindungsgemässen Stoffgemisch appliziert,

B) die Schicht in einem vorgegebenen Muster mit aktinischem Licht bestrahlt und

C) die belichtete (n) Stelle(n) der Schicht mit einer wässrigen Lösung einer Base entfernt.

Besonders bevorzugt sind erfindungsgemässe Stoffgemsiche, worin das in organischen Lösungsmitteln lösliche strahlungsempfindliche Präpolymer ein Polyamid mit wiederkehrenden Strukturelementen der Formel II

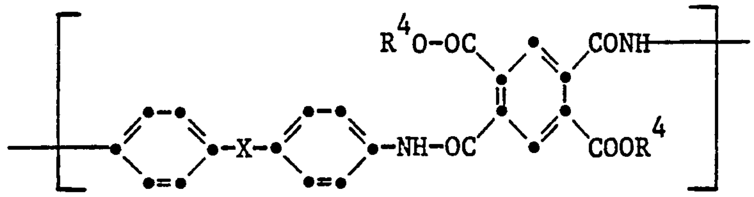

(II), worin

$R^4$ eine Gruppe der Formeln III bis VIII

$-CH_2-CH=CH_2$ (III) , 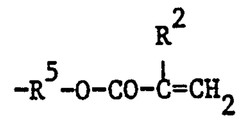 (VI),

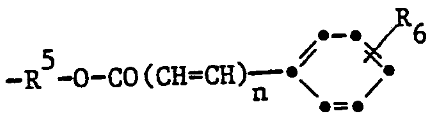 (V), 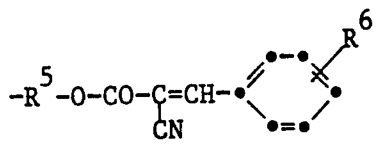 (VI),

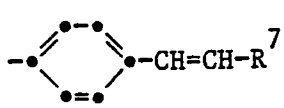 (VII) oder 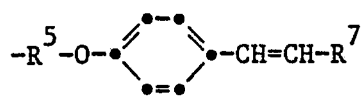 (VIII)

darstellt,

$R^2$ die oben angegebene Bedeutung hat,

$R^5$ eine Alkylengruppe, die an einem C-Atom durch eine Hydroxylgruppe substituiert sein kann,

$R^6$ ein Wasserstoff- oder Chloratom, eine Alkyl- oder Alkoxygruppe,

$R^7$ einen über ein Ring-C-Atom gebundenen carbocyclisch-aromatischen oder heterocyclischaromatischen Rest,

X ein kovalente Bindung, ein Sauerstoff- oder Schwefelatom, eine Alkylen-, Carbonyl- oder Sulfonylgruppe und n 1 oder 2 bedeuten, oder ein Polyamid mit wiederkehrenden Strukturelementen der Formel IX

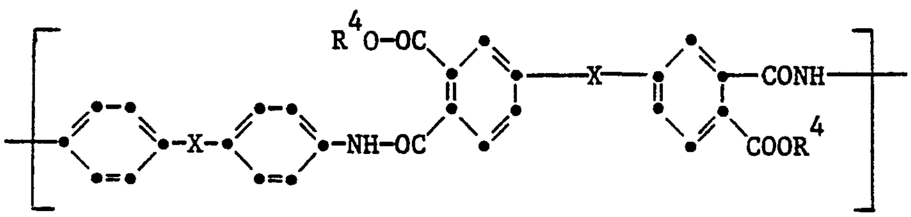

(IX)

ist, worin $R^4$ und X die oben angegebene Bedeutung haben.

Derartige Polyamide haben im allgemeinen ein Molekulargewicht im Bereich von 2000 bis 10000.

Wie bei den bekannten Verfahren zur Erzeugung von negativen Bildern aus Präpolymeren (i) können die nach dem erfindungsgemässen Verfahren erhaltenen Bilder erhitzt (getempert) werden, wobei noch hitzebeständige "Leitern"-Polymere mit durch Cyclisierung gebildeten heterocyclischen Kettengliedern erhalten werden. Wenn zum Beispiel ein Polyamid mit wiederkehrenden Strukturelementen der Formel II erfindungsgemäss zur Erzeugung von positiven Bildern verwendet wied, so wird das Polyamid durch Tempern des Bildes in ein Polyimid mit wiederkehrenden Strukturelementen der Formel X

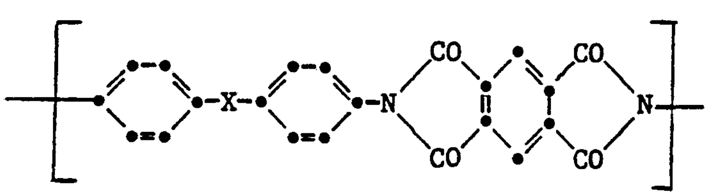

(X)

umgewandelt. Bei Verwendung eines Polyamids mit wiederkehrenden Strukturelementen der Formel IX wird das Polyamid durch Tempern des Bildes in ein Polyimid mit wiederkehrenden Strukturelementen der Formel XI

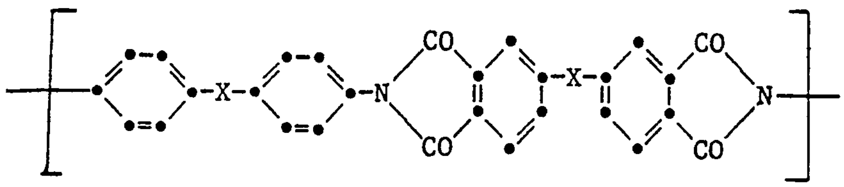

(XI)

umgewandelt. Dabei hat X die oben angegebene Bedeutung.

Das erfindungsgemässe Verfahren kann daher den folgenden zusätzlichen Schritt umfassen:

D) Erhitzen des verbliebenen Stoffgemisches unter Cyclisierung und Ausbildung von heterocyclischen Kettengliedern.

Gegenstand der Erfindung sind auch die nach dem obigen Verfahren erhaltenen positiven Bilder.

Es wird angenommen, dass durch die Bestrahlung des Gemisches aus dem Präpolymer (i) und der Säure der Formel I sowohl eine Vernetzung zwischen diesen beiden als auch zwischen Präpolymermolekülen bewirkt wird. Dabei wird ein lichtvernetztes Zwischenprodukt gebildet, das in organischen Lösungsmitteln unlöslich ist, aber noch von der Säure der Formel I abgeleitete freie Carbonsäuregruppen aufweist. Durch Behandlung solcher lichtvernetzter Produkte mit einer wässrigen Base findet an den freien Carbonsäuregruppen eine Salzbildung statt. Die so erhaltenen Salze sind in Wasser viel besser löslich als das in organischen Lösungsmitteln lösliche, aber in Wasser unlösliche Ausgangsmaterial. Die bestrahlten Stellen werden in der wässrigen Base in Salzform entfernt, und damit entsteht auf der Oberfläche des Substrats ein positives Bild.

Alkyl-, Alkoxy- und Alkylengruppen gemäss Formel I und den wiederkehrenden Strukturelementen der Formeln II und IX der Präpolymeren weisen bevorzugt 1—4 C-Atome auf. Besonders bevorzugt sind Präpolymere mit wiederkehrenden Strukturelementen der Formeln II und IX, worin $R^4$ eine Acryloyloxyalkyl-, Methacryloyloxyalkyl-, Acryloyloxyhydroxyalkyl- oder methacryloyloxyhydroxyalkylgruppe, besonders eine 2-(Acryoyloxy)äthyl-, 2-(Methacryloyloxy)äthyl-, 3-Acryloyloxy-2-hydroxypropyl- oder 3-Methacryloyloxy-2-hydroxypropylgruppe ist und X ein Sauerstoffatom eine Carbonylgruppe darstellt.

Als Säuren der Formel I werden solche bevorzugt, worin $R^3$ ein Wasserstoffatom oder eine direkt an einen aromatischen Ring mit einer oder zwei Carbonsäuregruppen oder an eine Alkylencarbonsäuregruppe gebundene Aethoxycarbonylgruppe darstellt. Beispiele geeigneter Carbonsäuren der Formel I sind Acrylsäure, Methacrylsäure und die folgenden Acrylatgruppen enthaltenden Säuren: 2-(2,4-Dicarboxyphenylcarbonyloxy)äthylacrylat, 2-(2,5-Dicarboxyphenylcarbonyloxy)äthylacrylat, 2-(2)Carboxyäthylcarbonyloxy)äthylacrylat, 1,5-Bis(2-(Acrloyloxy)äthoxycarbonyl)benzol-2,4-dicarbonsäure, 1,4-Bis-(2-Acryloyloxy)-äthoxycarbonyl)benzol-2,5-dicarbonsäure, 4,4'-Bis(2-(Acryloyloxy)äthoxycarbonyl)benzophenon-3,3'-dicarbonsäure, 3,3'-Bis(2-Acryloyloxy)äthoxycarbonyl)benzophenon-4,4'-dicarbonsäure, 3,4'-Bis(2-Acryloyloxy)äthoxycarbonyl)benzophenon-4,3'-dicarbonsäure, 2-(Acryloyloxy)äthyl-hydrogenphthalat sowie die entsprechenden Methacrylatgruppen enthaltenden Säuren.

Säuren der Formel I, worin $R^3$ eine über eine Estergruppe an eine Säure gebundene Alkylengruppe bedeutet, können z.B. auf an sich bekannte Weise durch Veresterung eines Di-, Tri- oder Tetracarbonsäureanhydrids mit Hydroxyalkylacrylaten oder -methacrylaten hergestellt werden.

Für die Photopolymerisation der erfindungsgemässen Stoffgemische wird erfindungsgemäss aktinisches Licht mit Wellenlängen von 200—600 nm bevorzugt. Geeignete Quellen für aktinisches Licht sind z.B. Kohlelichtbögen, Quecksilberdampflampen, Fluoreszenzlampen mit ultraviolettes Licht emittierenden Phosphoren, Argon- und Xenonglühlampen, Wolframlampen und photographische Flutlichtlampen. Queccksilberdampflampen, besonders Sonnenlampen, fluoreszierende Sonnellampen und Metallhalogenidlampen sind besonders bevorzugt. Die für die Belichtung der photopolymerisierbaren Stoffgemische benötigte Zeit kann von verscheidenen Faktoren abhängen, z.B. der Art der verwendeten Verbindungen, der Art der Lichtquelle und deren Abstand von dem belichteten Stoffgemisch. Geeignete Belichtungszeiten können vom Fachmann auf dem Photopolymerisationsgebiet leicht ermittelt werden.

Die Stoffgemische enthalten bevorzugt einen zusätzlichen Photoinitiator, d.h. einen Katalysator, der unter Belichtung einen angeregten Zustand ergibt, der seinerseits zur Bildung von freien Radikalen, die dann die Polymerisation der Stoffgemisches initiieren, führt. Geeignete Photoinitiatoren sind beispielsweise organische Peroxide und Hydroperoxide, α-halogensubstituierte Acetophenone, wie Trichlormethyl-4'-tert-butylphenylketon, α-hydroxy-α-alkyl-substituierte Acetophenone, wie 2-Hydroxy-2-methyl-1-phenylpropan-1-on, Benzoin und dessen Alkyläther (z.B. der Benzoin-n-butyläther), α-Methylbenzoin, Benzophenone, wie das unsubstituierte Benzophenon und 4,4'-Bis-(dimethylamino)-benzophenon (Michler's Keton), O-Alkoxycarbonylderivate eines Benziloxims oder eines 1-Phenylpropan-1,2-dions, wie Benzil(O-äthoxycarbonyl)α-monoxim und 1-Phenylpropan-1,2-dion-2-(O-äthoxycarbonyl)-oxim, Benzilketale, wie z.B. Benzildimethylketal, substituierte Thioxanthone, z.B. 2-Chlorthioxanthon, Anthrachinone sowie Photoredox-Systeme, die ein Gemisch aus einem Phenothiazinfarbstoff (z.B. Methylenblau) oder einem Chinoxalin (z.B. einem Metallsalz der 2-(m- oder p-Methoxyphenyl)-chinoxalin-6'- oder -7'-sulfonsäure) und einem Elektronendonator, wie Benzolsulfinsäure oder anderen Sulfinsäuren oder Salzen davon, wie die Natriumsalze, oder einem Arsin, Phosphin oder Thioharnstoff enthalten.

Geeignete Photoinitiatoren können leicht durch Routine-Versuche ermitteln werden. Im allgemeinen

werden 0,05 bis 10 Gew.%, insbesondere 0,5 bis 5% Gew.%, Photoinitiator, bezogen auf das Gesamtgewicht der Komponenten (i) und (ii), verwendet.

Die Stoffgemische können gewünschtenfalls einen carbonsäuregruppenfreien Acrylat- oder Methacrylatester, wie 2-Hydroxyäthylacrylat oder -methacrylat, 2-Hydroxypropylacrylat und -methacrylat, und 2-(2-Hydroxyäthoxy)-äthylacrylat und -methacrylat, enthalten.

Nach der Belichtung werden die belichteten Stellen des Stoffgemisches durch Behandlung mit einer wässrigen Lösung einer Base entfernt. Bevorzugte Lösungen für die Bildentwicklung sind 0,5 bis 5%ige wässrige Natrium- oder Kaliumcarbonat- oder Natrium- oder Kaliumhydroxid-Lösungen.

Die entwickelten Bilder bzw. das verbliebene Stoffgemisch werden zur Erzeugung von hitzebeständigen Strukturen vorzugsweise während 5 Minuten bis 3 Stunden auf Temperaturen zwischen 150 und 350°C erhitzt.

De Erfindung wird durch die folgenden Beispiele erläutert. Darin sind Teile und Prozente Gewichtsteile bzw. Gewichtsprozente.

Das in den Beispielen verwendete Präpolymer I wird nach der in Beispiel 2 der britischen Patentschrift 1.512.973 beschriebenen Methode aus Pyromellitsäuredianhydrid, 2-Hydroxyäthylmethacrylat und 4,4'-Diaminodiphenyläther hergestellt.

Präpolymer II wird wie folgt hergestellt: 20,0 g Pyromellitsäuredianhydrid, 21,0 ml trockenes N-Methylpyrrolidon und 30,0 ml trockenes Pyridin werden zusammen gerührt und währ end 1/2 Stunde mit 21,4 g trockenem 2-Hydroxyäthylacrylat versetzt, wobei die Temperatur des Gemisches unter 30°C gehalten wird. Das Gemisch wird während weiterer 3 Stunden bei Raumtemperatur gerührt. Danach beträgt die Säurezahl des Gemisches 36,6 mg KOH/g. Das Gemisch wird anschliessend auf 12—15°C gekühlt. Im Verlaufe von 1 Stunde gibt man 36,0 ml Thionylchlorid zu. Es wird noch eine weitere Stunde bei 12—15°C gerührt, worauf man 15,0 g 4,4'-Diaminodiphenyläther und 45,0 ml N-Methylpyrrolidon zugibt. Das Gemisch wird über Nacht gerührt, wobei man dessen Temperatur auf Raumtemperatur ansteigen lässt. Dann wird das Gemisch mit 50 ml Aethanol behandelt, und während 2 Stunden bei Raumtemperatur gerührt. Man gibt 407,5 ml Wasser zu, rührt das Gemisch während 2 Stunden und versetzt schliesslich mit 62,5 ml Aethanol, wobei ein braunes Oel ausfällt. Das Oel wird durch Dekantieren von der oberen Schicht abgetrennt und in 50 ml N-Methylpyrrolidon gelöst. Die erhaltene Lösung gibt man langsam zu 2 Liter Wasser. Es fällt ein gelber Niederschlag aus, der abfiltriert und bei 40°C unter Vakuum getrocknet wird. Man erhält Präpolymer II.

Präpolymer III wird wie folgt hergestellt: 11,9 g 4,4'-Diaminobenzophenon werden in 120 ml Dimethylacetamid gelöst. Anschliessend werden im Verlaufe von 5 Minuten 21,0 g 3,3',4,4'-Benzophenontetracarbonsäuredianhydrid zugegeben, wobei die Temperatur ds Gemisches unter 30°C gehalten wird. Das Gemisch wird dann noch 2 Stunden bei Raumtemperatur gerührt. Man gibt 0,49 g 2-Hydroxyäthylmethacrylat zu und rührt das Gemisch noch während weiterer 2 Stunden bei Raumtemperatur. Anschliessend gibt man 50 ml Glycidylmethacrylat, 0,4 g Benzyldimethylamin und 0,2 g Hydrochinon zu und erhitzt das Gemisch auf 60°C. Das Gemisch wird 19 Stunden bei 60°C gerührt und dann abgekühlt. Das Polymer wird durch langsame Zugabe von 500 ml eines Gemisches aus Diäthyläther und Aethanol (1:1-Volumenverhältnis) ausgefällt. Der so erhaltene gelbe Feststoff wird abfiltriert und im Vakuum getrocknet. Man erhält ein Polymer mit einer Säurezahl von 32,5 mg KOH/g. 10,0 g dieses Polymeren werden in 100 Dimethylacetamid gelöst. Dann gibt man 1,24 g Glydidylmethacrylat, 0,04 g Benzyldimethylamin und 0,02 g Hydrochinon zu. Das erhaltene Gemisch wird 10 Stunden auf 60°C erhitzt, und das Reaktionsprodukt wird wie oben beschrieben ausgefällt. Man erhält einen gelben Feststoff mit einer vernachlässigbaren Säurezahl. Dieser gelbe Feststoff ist das Präpolymer III.

Die in den Beispielen verwendeten und nicht im Handel erhältlichen Säuren werden wie folgt hergestellt:

2-(2-Carboxyäthylcarbonyloxy)äthylacrylat

Ein Gemisch aus 30,0 g Bernsteinsäureanhydrid, 34,2 g 2-Hydroxyäthylacrylat, 0,2 g Tetramethylammoniumchlorid und 0,15 g 2,6-Di-tert-butyl-4-methylphenol werden bei 90°C 3 Stunden erhitzt. Nach dieser Zeit zeigt das infrarot-Spektrum des Gemisches, dass praktisch das gesamte Anhydrid reagiert hat. Durch Abkühlen des Gemisches erhält man die gewünschte Säure.

Gemisch aus 2-(2,4- und 2,5-Dicarboxyphenylcarbonyloxy)äthylacrylat

Eine Lösung von 166,4 g Trimellitsäureanhydrid, 106,0 g 2-Hydroxyäthylacrylat, 163,6 N-Methylpyrrolidon, 1,2 g Tetramethylammoniumchlorid und 0,8 g 2,6-Di-tert-butyl-4-methylphenol wird bei 90°C drei Stunden gerührt. Danach zeigt das Infrarot-Spektrum der Lösung nur noch Spuren des Anhydrids. Diese Lösung wird als Säuregemisch I bezeichnet.

Gemisch aus Bis-(2-(Methacryloyloxy)äthoxycarbonyl)benzophenondicarbonsäuren

193,2 g 3,3',4,4'-Benzophenontetracarbonsäuredianhydrid, 190,0 g 2-Hydroxyäthylmethacrylat, 0,9 g Tetramethylammoniumchlorid und 0,6 g 2,6-Di-tert-butyl-4-methylphenol werden gemischt und 2 Stunden auf 80°C erhitzt. Das Gemisch wird abgekühlt. Dann gibt man nochmals 122,0 g 2-Hydroxyäthylmethacrylat zu. Das Gemisch wird wieder 2 Stunden auf 80°C erhitzt und dann abgekühlt. Gemäss Infrarot-Spektrum hat das Gemisch einen vernachlässigbaren Anhydridgehalt. Es stellt, auf molarer Basis, ein 2:1-Gemisch aus 2-Hydroxyäthylacrylat und den drei Bis-(2-(methacryloyloxy)äthoxycarbonyl)benzophenondicarbonsäuren, d.h. der 4,4'-disubstituierten 3,3'-Dicarbonsäure, der 3,3'-disubstituierten 4,4'-Dicarbonsäure und der 3,4'-disubstituierten 4,3'-Dicarbonsäure, dar. Dieses Produkt wird im folgenden mit Säuregemisch II bezeichnet.

Beispiel 1

5 Teile Präpolymer I, 0,1 Teil Acrylsäure, 0,15 Teile Benzildimethylketal und 7 Teile N-methylpyrrolidon werden gemischt und auf ein kupferkaschiertes Laminat appliziert. Die Beschichtung wird 1 Stunde bei 50°C getrocknet und ergibt einen 4 µm dicken klebefreien Film. Der Film wird 20 Minuten mit einer 30 W/cm Mitteldruckquecksilberlampe in einem Abstand von 22 cm belichtet. Nach der Belichtung wird das Bild unter leichtem Bürsten durch Eintauchen in eine 2%ige wässrige Natriumhydroxidlösung entwickelt. Die belichteten Stellen werden so weggewaschen, und auf dem Kupfer bleibt ein gutes positives Bild zurück.

Beispiel 2

Beispiel 1 wird wiederholt, wobei die Acrylsäure durch 0,1 Teil 2-(2-Carboxyäthylcarbonyloxy)äthylacrylat ersetzt wird. Man erhält auf dem Kupfer ein gutes positives Bild.

Beispiel 3

Beispiel 1 wird wiederholt, wobei die Acrylsäure durch 0,1 Teil des Säuregemisches I ersetzt wird. Man erhält ein gutes positives Bild auf dem Kupfer. Die nicht beschichteten Stellen des Kupfers werden dann bei 35°C mit einer wässrigen Lösung von Eisen(III)chlorid (41% $FeCl_3$) geätzt. Die beschichteten Stellen werden dabei nicht beeinträchtigt.

Beispiel 4

Beispiel 1 wird wiederholt unter Verwendung von 0,3 Teilen Acrylsäure. Das positive Bild wird unter leichtem Bürsten in 1%igem wässrigem Natriumhydroxid entwickelt.

Beispiel 5

Beispiel 1 wird wiederholt, wobei man die Acrylsäure durch 0,2 Teile des Säuregemisches I und 0,7 Teile des Säuregemisches II ersetzt. NAch dem Eintauchen in 2%ige wässrige Nariumhydroxidlösung erhält man ein gutes positives Bild. Das das Bild aufweisende Laminat wird zum Tempern des Harzes während 10 Minuten auf 300°C erhitzt. Das Bild verbleibt auf dem Laminat und wird durch weiteres Erhitzen bei 300°C nicht beeinträchtigt.

Beispiel 6

5,0 Teile Präpolymer II, 5,0 Teile N-Methylpyrrolidon, 0,4 Teile Säuregemisch I, 0,6 Teile Säuregemisch II und 0,1 Teil Michler's Keton werden auf ein kupferkaschiertes Laminat appliziert und 1 Stunde bei 50°C getrocknet, wobei ein 10 µm dicker klebefreier Film entsteht. Dieser wird 5 Minuten mit einer 500 W Metallhalogenidlampe in einem Abstand von 750 mm bestrahlt. Nach dem Entwickeln in 1%iger wässriger natriumhydroxidlösung erhält man ein gutes positives Bild.

Beispiel 7

5,0 Teile Präpolymer III, 10,0 Teile N-Methylpyrrolidon, 0,2 Teile benzilidimethylketal und 0,04 Teile Acrylsäure werden auf ein kupferkaschiertes Laminat appliziert und 1 Stunde bei 50°C getrocknet, wobei ein klebefreier Film entsteht. Dieser wird in einem Abstand von 750 mm mit einer 5000 W Metallhalogenidlampe bestrahlt. Durch Entwickeln in 2%iger wässriger Natriumhydroxidlösung erhält man ein positives Bild.

**Patentansprüche**

1. Stoffgemisch, enthaltend

(i) ein in organischen Lösungsmitteln lösliches strahlungsempfindliches Präpolymer, das ein Polyadditions- oder Polykondensationsprodukt aus

(1) mindestens einer mehrwertigen carbocyclischen Verbindung und/oder heterocyclischen Verbindung mit mindestens zwei zu Additions- oder Kondensationsreaktionen befähigten Gruppen R und

(2) mindestens einer mehrwertigen carbocyclischen Verbindung und/oder heterocyclischen Verbindung mit mindestens zwei Gruppen, die mit den Gruppen R Additions- oder Kondensationsreaktionen eingehen können, ist, wobei das Präpolymer in ortho- oder peri-Stellung zu einer durch Umsetzung einer Gruppe R gebildeten Gruppe mindestens eine Gruppe —$COOR^1$ aufweist, worin $R^1$ einen organischen Rest mit einer oder mehr Doppel- oder Dreifachbindungen, die unter Bestrahlung dimerisieren oder polymerisieren können, darstellt, und

(ii) 1—25 Gew.%, bezogen auf das Gewicht des Präpolymeren (i), einer ungesättigten Mono- oder Dicarbonsäure der Formel I

$$CH_2{=}\underset{\underset{R^2}{|}}{C}{-}COOR^3 \qquad (I),$$

worin

$R^2$ ein Wasserstoffatom oder eine Methylgruppe und

$R^3$ ein Wasserstoffatom oder eine über eine Estergruppe an eine aromatische oder aliphatische Mono- oder Dicarbonsäure gebunden Alkylenkette, die eine oder zwei weitere Gruppen

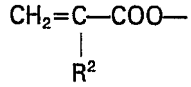

enthalten kann, darstellen.

2. Stoffgemisch nach Anspruch 1, worin das Präpolymer (i) ein Produkt ist, das erhalten wird durch Umsetzung (3) mindestens einer mehrwertigen carbocyclischen und/oder heterocyclischen Verbindung mit mindestens zwei Gruppen R wie in Anspruch 1 definiert und mindestens einer Gruppe —$COOR^1$ wie in Anspruch 1 definiert in ortho- oder peri-Stellung zu einer Gruppe R, und (4) mindestens einer mehrwertigen carbocyclischen Verbindung und/oder heterocyclischen Verbindung mit mindestens zwei Gruppen, die mit den Gruppen R Additions- oder Kondensationsreaktionen eingehen können.

3. Stoffgemisch nach Anspruch 2, worin das Präpolymer (i) ein Polyamid ist, das aus einer Säure mit zwei oder mehr Carbonsäuregruppen als Gruppen R und mit einer oder mehreren Gruppen—$COOR^1$ erhalten wird, indem man

(a) die Carbonsäuregruppen in Säurechloridgruppen überführt und das erhaltene Säurechlorid mit einer Verbindung mit zwei oder mehr Aminogruppen umsetzt, oder

(b) die Säure mit einer zwei oder mehr Isocyanatgruppen aufweisenden Verbindung umsetzt.

4. Stoffgemisch nach Anspruch 1, worin das Präpolymer (i) ein Produkt ist, das durch Umsetzung eines carbonsäuregruppenhaltigen Polyadditions- oder Polykondensationsproduktes aus

(5) mindestens einer mehrwertigen carbocyclischen Verbindung und/oder heterocyclischen Verbindung mit mindestens zwei Gruppen R wie in Anspruch 1 definiert und

(b) mindestens einer mehrwertigen carbocyclischen Verbindung und/oder heterocyclischen Verbindung mit mindestens zwei Gruppen, die mit den Gruppen R Additions- oder Kondensationsreaktionen eingehen können, mit

(7) einer Verbindung, die mindestens eine Gruppe —$COOR^1$ gemäss Anspruch 1 und mindestens eine zur Umsetzung mit Carbonsäuregruppen geeignete Gruppe aufweist, erhalten wird, wobei sich die Carbonsäuregruppe in dem Polyadditions- oder Polykondensationsprodukt in orth- oder peri-Stellung zu einer durch Umsetzung einer Gruppe R gebildeten Gruppe befindet.

5. Stoffgemisch nach Anspruch 4, worin das Präpolymer (i) durch Umsetzung eines Polyamids mit freien Carbonsäuregruppen mit einem Glycidylgruppen enthaltenden Acrylat oder Methacrylat erhalten wird.

6. Stoffgemisch nach Anspruch 1, worin das Präpolymer (i) ein Polyamid mit wiederkehrenden Strukturelementen der Formel II

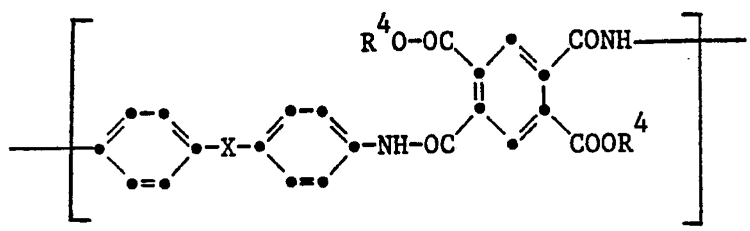

(II) ist,

worin

$R^4$ eine Gruppe der Formeln III bis VIII

$-CH_2-CH=CH_2$ (III),

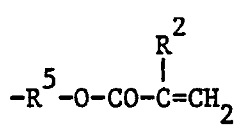

(IV),

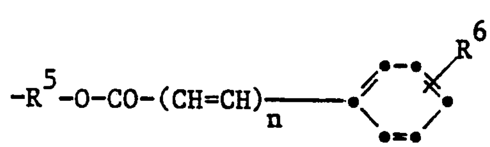

(V),

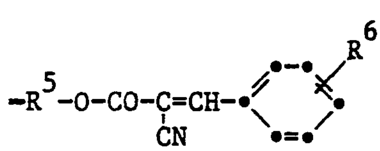

(VI),

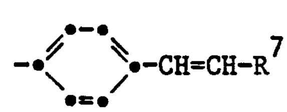

(VII)

oder

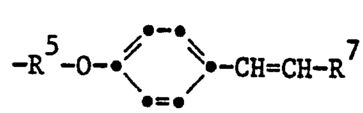

(VIII),

$R^5$ eine Alkylengruppe, die an einem C-Atom durch eine Hydroxylgruppe substituiert sein kann,

$R^6$ ein Wasserstoff- oder Chloratom oder eine Alkyl- oder Alkoxygruppe,

$R^7$ einen über ein Ringkohlenstoffatom gebundenen carbocyclischaromatischen oder heterocyclischaromatischen Rest,

X eine kovalente Bindung, ein Sauerstoff- oder Schwefelatom, eine Alkylengruppe, eine Carbonyl- oder Sulfonylgruppe und n 1 oder 2 bedeuten, und $R^2$ die in Anspruch 1 angegebene Bedeutung hat, oder worin das Präpolymer (i) ein Polyamid mit wiederkehrenden Strukturelementen der Formel IX

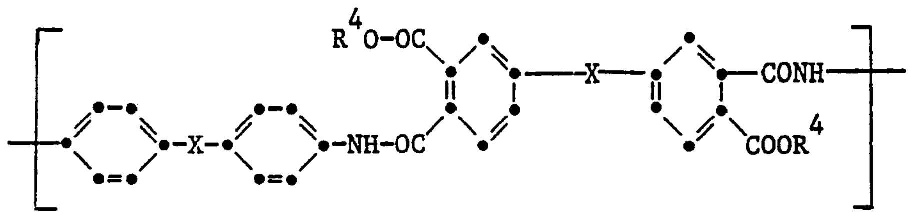

(IX)

ist, worin X und $R^4$ die oben angegebene Bedeutung haben.

7. Stoffgemisch nach Anspruch 6, worin $R^4$ eine Acryloyloxyalkyl-, Methacrylolyloxyalkyl-, Acryloyloxyhydroxyalkyl- oder Methacryloyloxyhydroxyalkylgruppe darstellt.

8. Stoffgemisch nach Anspruch 1, worin $R^3$ in der Säure der formel I ein Wasserstoffatom oder eine direkt an eine aromatische Gruppe mit einer oder zwei Carbonsäuregruppen oder an eine Alkylencarbonsäuregruppe gebundene Aethoxycarbonylgruppe bedeutet.

9. Verfahren zur positiven Bilderzeugung, dadurch gekennzeichnet, dass man

A) auf ein Substrat eine Schicht aus einem Stoffgemisch nach Anspruch 1 appliziert,

B) diese Schicht in einem vorgegebenen Muster mit aktinischem Licht bestrahlt und

C) die bestrahlene(n) Stelle(n) der Schicht mit einer wässrigen Lösung einer Base entfernt.

10. Verfahren nach Anspruch 9, worin das verbliebene Stoffgemisch während 5 Minuten bis 3 Stunden auf 150—350°C erhitzt wird.

**Revendications**

1. Mélange qui contient:

(I) un prépolymère photosensible, soluble dans des solvants organiques, qui est un produit de polyaddition ou de polycondensation dérivant:

(1) d'au moins un composé carbocyclique multivalent et/ou d'un composé hétérocyclique multivalent renfermant au moins deux radicaux R capables de donner des réaction d'addition ou de condensation, et

(2) d'au moins un composé carbocyclique multivalent et/ou d'un composé hétérocyclique multivalent renfermant au moins deux radicaux capables de donner, avec les radicaux R, des réactions d'addition ou de condensation,

le prépolymère portant, en position ortho ou péri relativement à un radical formé par réaction d'un radical R, au moins un radical —$COOR^1$ dans lequel $R^1$ représente un radical organique renfermant une ou plusieurs liaisons doubles ou triples capables de donner des réactions de dimérisation ou de polymérisation sous l'effet d'un rayonnement, et

(II) de 1 à 25% en poids, par rapport au poids du prépolymère (I), d'un acide monocarboxylique ou dicarboxylique insaturé répondant à la formule I

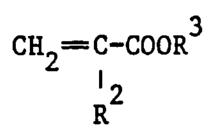

(I),

dans laquelle $R^2$ représente un atome d'hydrogène ou un radical méthyle et $R^3$ représente un atome d'hydrogène ou une chaîne alkylène qui est reliée par un radical d'ester à un acide monocarboxylique ou dicarboxylique aromatique ou aliphatique et qui peut contenir un ou deux autres radicaux

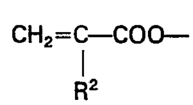

2. Mélange selon la revendication 1 dans lequel le prépolymère (I) est un produit que l'on a obtenu en faisant réagir (3) au moins un composé carbocyclique et/ou hétérocyclique multivalent contenant au moins deux radicaux R tels que définis à la revendication 1 et au moins un radical —$COOR^1$ tel que défini à la revendication 1, en position ortho ou péri relativement au radical R, et (4) au moins un composé carbocyclique et/ou un composé hétérocyclique multivalents renfermant au moins deux radicaux capables de donner des réactions d'addition ou de condensation avec les radicaux R.

3. Mélange selon la revendication 2 dans lequel le prépolymère (I) est un polyamide qu'on a obtenu à partir d'un acide renfermant deux ou plus de deux radicaux carboxy en tant que radicaux R et un ou plusieurs radicaux —$COOR^1$, en opérant de la façon suivante:

(a) on transforme les radicaux carboxy en radicaux chlorocarbonyles et on fait réagir le chlorure d'acide obtenu avec un composé contenant deux ou plus de deux radicaux amino, ou

(b) on fait réagir l'acide avec un composé contentant deux ou plus de deux radicaux isocyanato.

4. Mélange selon la revendication 1 dans lequel le prépolymère (I) est un produit qu'on a obtenu en faisant réagir un produit de polyaddition ou de polycondensation contenant des radicaux carboxy et dérivant:

(5) d'au moins un composé carbocyclique et/ou d'un composé hétérocyclique multivalents renfermant au moins deux radicaux R tels que définis à la revendication 1, et

(6) d'au moins un composé carbocyclique et/ou d'un composé hétérocyclique multivalents renfermant au moins deux radicaux capables de donner des réactions d'addition ou de condensation avec les radicaux R, avec

(7) un composé contenant au moins un radical —$COOR^1$ selon la revendication 1 et au moins un radical capable de réagir avec des radicaux carboxy,

le radical carboxy, dans le produit de polyaddition ou de polycondensation, étant en position ortho ou péri relativement à un radical formé par réaction d'un radical R.

5. Mélange selon la revendication 4 dans lequel le prépolymere (I) a été obtenu par réaction d'un polyamide renfermant des radicaux carboxy libres avec un acrylate ou un méthacrylate renfermant des radicaux glycidyles.

6. Mélange selon la revendication 1 dans lequel le prépolymère (I) est un polyamide comportant des unités structurales répétées répondant à la formule II:

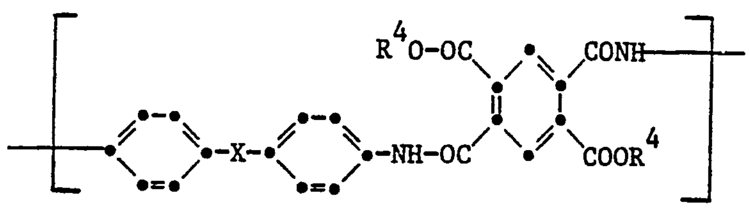 (II),

dans laquelle

$R^4$ représente un radical répondant à l'une des formules III à VIII:

$-CH_2-CH=CH_2$ (III) , 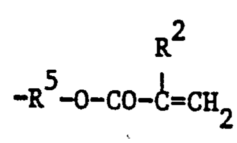 (VI),

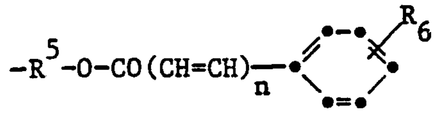 (V), 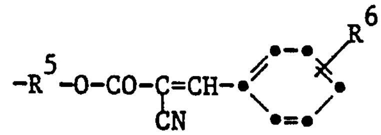 (VI),

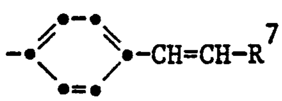 (VII) 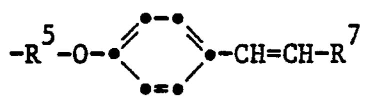 (VIII)

$R^2$ a la signification qui lui a été donnée à la revendication 1,

$R^5$ représente un radical alkylène qui peut porter un radical hydroxy sur un atome de carbone,

$R^6$ représente un atome d'hydrogène ou de chlore ou un radical alkyle ou alcoxy,

$R^7$ représente un radical aromatique carbocyclique ou aromatique hétérocyclique lié par un atome de carbone du cycle, et

n désigne un nombre égal à 1 ou à 2, et

X représente une liaison covalente, un atome d'oxygène ou de soufre, ou un radical alkylène, carbonyle ou sulfonyle,

ou dans lequel le prépolymère (I) est un polyamide comportant des unités structurales répétées répondant à la formule IX:

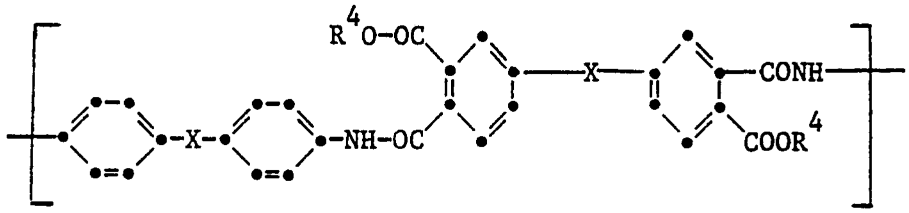

(IX)

dans laquelle X et $R^4$ ont les significations indiquées ci-dessus.

7. Mélange selon la revendication 6 dans lequel $R^4$ représente un radical acryloyloxy-alkyle, méthacryloyloxy-alkyle, acryloyloxy-hydroxy-alkyle ou méthacryloyloxy-hydroxy-alkyle.

8. Mélange selon la revendication 1 dans lequel le symbole $R^3$ contenu dans la formule I de l'acide représente un atome d'hydrogène ou un radical carbonyloxy-éthyle lié directement à un radical aromatique porteur d'un ou deux radicaux carboxy ou à un radical carboxy-alkylène.

9. Procédé pour réaliser des images positives, procédé caractérisé en ce que:

A) on applique sur un substrat une couche d'un mélange selon la revendication 1;

B) on expose dcette couche à un rayonnement actinique conformément à un modèle donné et

C) on élimine au moyen d'une solution aqueuse d'une base le ou les endroits de la couche qui ont été touchés par le rayonnement.

10. Procédé selon la revendication 9 dans lequel on chauffe le mélange restant pendant 5 minutes à 3 heures à une température de 150 à 350°C.

**Claims**

1. A composition containing

(i) an organic solvent-soluble, radiation-sensitive prepolymer which is a polyadddition or polycondensation product of

(1) at least one polyfunctional carbocyclic compound and/or heterocyclic compound containing at least two groups R capable of undergoing an addition or condensation reaction , and

(2) at least one polyfunctional carbocyclic compound and/or heterocyclic compound containing at least two groups capable of undergoing an addition or condensation reaction with the groups R, the prepolymer having at least one group $-COOR^1$ in the ortho- or peri-position with respect to a group formed by reaction of a group R, in which $R^1$ is an organic radical with one or more double or triple bonds which can dimerise or polymerise on irradiation, and

(ii) 1—25% by weight calculated on the weight of the prepolymer (i), of an unsaturated mono- or dicarboxylic acid of the formula I

$$CH_2{=}\underset{\displaystyle R^2}{\underset{|}{C}}{-}COOR^3 \qquad (I),$$

in which

$R^2$ is a hydrogen atom or a methyl group and

$R^3$ is a hydrogen atom or an alkylene chain linked through an ester group to an aromatic or aliphatic mono- or dicarboxylic acid and which may contain one or two further groups

$$CH_2{=}\underset{\displaystyle R^2}{\underset{|}{C}}{-}COO{-}.$$

2. A composition according to claim 1, in which the prepolymer (i) is a product formed by reacting

(3) at least one polyfunctional carbocyclic and/or heterocyclic compound containing at least two groups R, as defined in claim 1, and at least one group $-COOR^1$, as defined in claim 1, in the ortho- or peri-position with respect to a group R, and

(4) at least one polyfunctional carbocyclic compound and/or heterocyclic compound containing at least two groups capable of undergoing an addition or condensation reaction with the groups R.

3. A composition according to claim 2, in which the prepolymer (i) is a polyamide obtained from an acid having two or more carboxyl groups as the groups R and having one or more groups $-COOR^1$

(a) by converting the carboxyl groups into acid chloride groups and reacting the resulting acid chloride with a compound having two or more amino groups, or

(b) by reaction of the acid with a compound having two or more isocyanate groups.

4. A composition according to claim 1, in which the prepolymer (i) is a product obtained by reacting a carboxyl group-containing polyaddition or polycondensation product of

(5) at least one polyfunctional carbocyclic compound and/or heterocyclic compound containing at least two groups R as defined in claim 1, and

(6) at least one polyfunctional carbocyclic compound and/or heterocyclic compound containing at least two groups capable of undergoing an addition or condensation reaction with the groups R, with

(7) a compound containing at least one group —$COOR^1$ as defined in claim 1, and at least one group suitable for reaction with a carboxyl group, the carboxyl group in the polyaddition or polycondensation product being in the ortho- or peri-position with respect to a group formed by reaction of a group R.

5. A composition according to claim 4, in which the prepolymer (i) is obtained by reaction of a polyamide having free carboxyl groups with a glycidyl group-containing acrylate or methacrylate.

6. A composition according to claim 1, in which the prepolymer (i) is a polyamide having repeating structural elements of the formula II

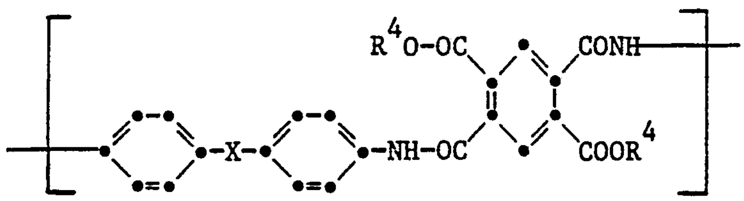

(II),

in which

$R^4$ is a group of the formulae III to VIII

$-CH_2-CH=CH_2$ (III) ,

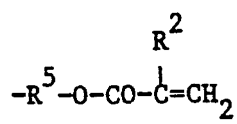

(VI),

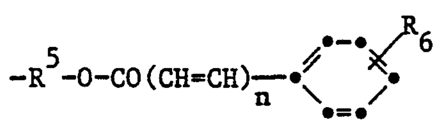

(V),

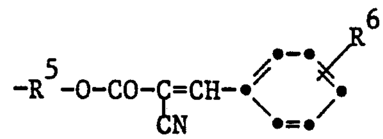

(VI),

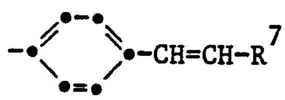

(VII) or

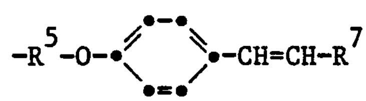

(VIII)

$R^5$ is an alkylene group which may be substituted on one carbon atom by a hydroxyl group,

$R^6$ is a hydrogen or chlorine atom or an alkyl or alkoxy group,

$R^7$ is a carbocyclic aromatic or heterocyclic aromatic radical attached through a ring carbon atom,

X is a covalent bond, an oxygen or sulphur atom, an alkylkene group, a carbonyl group, or a sulphonyl group, and n is 1 or 2, and $R^2$ is as defined in claim 1,

or in which the prepolymer (i) is a polyamide having repeating structural elements of the formula IX

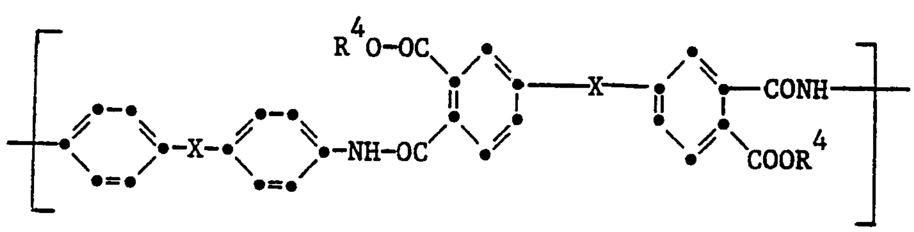

(IX)

in which X and $R^4$ are as defined above.

7. A composition according to claim 6, in which $R^4$ is an acryloyloxyalkyl, methacryloyloxyalkyl, acryloyloxyhydroxyalkyl or methacryloyloxyhydroxyalkyl group.

8. A composition according to claim 1, in which $R^3$ in the acid of the formula I is a hydrogen atom or an ethoxycarbonyl group linked directly to an aromatic group having one or two carboxyl groups or to an alkylene carboxyl group.

9. A process for the formation of a positive image which comprises

A) Applying to a substrate a layer of a composition according to claim 1,

B) irradiating this layer with actinic light in a predetermined pattern, and

C) removing the irradiated part or parts of the layer by means of an aqueous solution of a base.

10. A process according to claim 9, in which the residual composition is heated at 150—350°C for a period of from 5 minutes to 3 hours.